(19) Europäisches Patentamt
European Patent Office
Office européen des brevets

(11) **EP 3 152 406 B1**

(12) **FASCICULE DE BREVET EUROPEEN**

(45) Date de publication et mention de la délivrance du brevet:
**29.08.2018 Bulletin 2018/35**

(21) Numéro de dépôt: **15732841.0**

(22) Date de dépôt: **03.06.2015**

(51) Int Cl.:
**F01D 11/14** *(2006.01)*

(86) Numéro de dépôt international:
**PCT/FR2015/051466**

(87) Numéro de publication internationale:
**WO 2015/185857 (10.12.2015 Gazette 2015/49)**

(54) **PROCÉDÉ DE DIMENSIONNEMENT D'UNE TURBOMACHINE**

VERFAHREN ZUR DIMENSIONIERUNG EINER TURBOMASCHINE

METHOD FOR DIMENSIONING A TURBOMACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.06.2014 FR 1455190**

(43) Date de publication de la demande:
**12.04.2017 Bulletin 2017/15**

(73) Titulaires:
- **SAFRAN AIRCRAFT ENGINES**
  **75015 Paris (FR)**
- **Ecole Centrale de Lyon**
  **69130 Ecully (FR)**
- **Centre National de la Recherche Scientifique (CNRS)**
  **75016 Paris (FR)**
- **Ecole Nationale d'Ingénieurs de Saint-Etienne**
  **42100 Saint-Etienne (FR)**

(72) Inventeurs:
- **PARENT, Marie-Océane**
  **F-75015 Paris (FR)**
- **CHEVILLOT, Fabrice, Joël, Luc**
  **F-75015 Paris (FR)**
- **THOUVEREZ, Fabrice, Hugues, Jean, Pierre**
  **F-69160 Tassin-la-Demi-Lune (FR)**

(74) Mandataire: **Regimbeau**
**20, rue de Chazelles**
**75847 Paris Cedex 17 (FR)**

(56) Documents cités:
**EP-A2- 1 890 009     DE-A1- 10 352 790**
**GB-A- 2 483 061**

**Description**

DOMAINE TECHNIQUE GENERAL

La présente invention concerne la conception assistée par ordinateur. Plus précisément, elle concerne un procédé de dimensionnement d'une turbomachine, en particulier d'un turboréacteur d'aéronef.

ETAT DE LA TECHNIQUE

Les performances de fonctionnement d'une turbomachine, telle qu'un turboréacteur d'aéronef, dépendent grandement de l'espacement entre les parties tournantes et les parties fixes de la turbomachine. Réduire un tel espacement au minimum, par exemple entre les aubes de la turbomachine et son carter, permet de limiter les fuites et donc en général de maximiser les performances de la turbomachine d'un point de vue hydraulique. Néanmoins, si cet espacement est faible, des contacts risquent de se produire entre les aubes et le carter de la turbomachine. De tels contacts, s'ils produisent des forces de réaction trop importantes ou des vibrations à des fréquences inappropriées, peuvent entrainer un endommagement de la turbomachine. De tels risques existent particulièrement dans les turbomachines modernes employant aussi bien pour les parties mobiles que fixes des matériaux légers mais flexibles et donc sujets à déformation et vibration.

Il est donc nécessaire de dimensionner cet espacement au plus juste pour permettre l'obtention de bonnes performances sans pour autant risquer de détériorer la turbomachine ou ses performances du fait de contacts entre ses parties fixes et tournantes. Un exemple de procédé de dimensionnement d'une turbomachine est décrit dans la demande EP 1 890 009. Une première catégorie de modèles utilisés pour un tel dimensionnement regroupe les modèles de roues aubagées. Ces modèles prennent en compte la flexibilité des aubes et du disque les supportant et permettent d'analyser le comportement vibratoire de ces éléments. Des modèles en trois dimensions 3D aux éléments finis sont notamment utilisés pour représenter finement la géométrie des aubes et du carter autour de l'extrémité des aubes et estimer le comportement de contact entre les aubes et le carter. De tels modèles sont néanmoins locaux et ne prennent pas en compte le comportement mécanique dynamique de l'arbre de rotation de la turbomachine et du reste de celle-ci. De plus, les calculs utilisant de tels modèles consomment une quantité importante de ressources.

Une deuxième catégorie de modèles utilisés pour le dimensionnement des turbomachines regroupe les modèles de dynamique des rotors. De tels modèles incluent une modélisation de l'ensemble des éléments de la turbomachine permettant d'analyser le comportement vibratoire du rotor de la turbomachine. De tels modèles n'utilisent pas de discrétisation de la géométrie afin de limiter la quantité de ressources informatiques consommées par un calcul. Néanmoins, de tels modèles utilisent généralement une modélisation simplifiée et rigide des aubes et du carter de la turbomachine et ne permettent ainsi pas de calculer précisément les interactions de contact entre les aubes et le carter pour le dimensionnement de la turbomachine.

Il existe donc un besoin d'un procédé de dimensionnement de turbomachine permettant de calculer précisément les interactions de contact entre les aubes et le carter, tout en prenant en compte le comportement mécanique du rotor et les vibrations et déformations des aubes, du disque et du carter, pour un coût en ressources informatiques limité.

PRESENTATION DE L'INVENTION

La présente invention propose selon un premier aspect un procédé de dimensionnement d'une turbomachine comprenant un carter et un disque sur lequel est fixée au moins une aube, ledit carter entourant le disque et l'au moins une aube, ledit disque étant entrainé en rotation par un arbre autour d'un axe, dit axe de la turbomachine z, et ladite aube comprenant un bord d'attaque BA et un bord de fuite BF,
ledit procédé étant caractérisé en ce qu'il comprend la mise en oeuvre par des moyens de traitement de données d'étapes de :

- acquisition des coordonnées P des extrémités du bord d'attaque et du bord de fuite de l'aube dans un repère lié au disque $(Xb, Yb, Zb)$ déterminées préalablement;
- à partir desdites coordonnées acquises P, expression des coordonnées P' des extrémités supérieures du bord d'attaque et du bord de fuite de l'aube dans un repère lié au carter $(x_c, y_c, z_c)$;
- calcul de la distance g entre le carter et les extrémités du bord d'attaque et du bord de fuite de l'aube à partir des coordonnées P' des extrémités du bord d'attaque et du bord de fuite de l'aube dans le repère lié au carter $(x_c, y_c, z_c)$;
- calcul des pressions de contact entre l'aube et le carter normales et tangentielles le long de l'extrémité de l'aube à partir de la distance calculée g ;
- calcul des forces de réaction normale et tangentielle et des moments de réaction normal et tangentiel résultant du contact entre l'aube et le carter à partir des pressions calculées ;

- dimensionnement de la turbomachine en fonction des distances, pressions, forces et moments calculés.

Un tel procédé permet de dimensionner la turbomachine à partir d'un calcul précis des possibilités de contacts et des réactions associées sans avoir à utiliser une modélisation locale fine et couteuse, comme une modélisation 3D aux éléments finis.

Les coordonnées des extrémités du bord d'attaque et du bord de fuite de l'aube dans le repère lié au carter $(x_c, y_c, z_c)$ peuvent être exprimées en fonction de degrés de liberté du disque, du carter et de l'aube.

Ces degrés de liberté peuvent être parmi des translations et basculements du disque et du carter, un fléchissement de l'aube à son sommet et une déformation radiale du carter.

Plus précisément, ces degrés de liberté peuvent être parmi :

- des translations du disque d'une première longueur $x_d(t)$ et d'une deuxième longueur $y_d(t)$ selon deux axes $(x, y)$ transverses à l'axe de la turbomachine z, les deux axes transverses $(x,y)$ et l'axe de la turbomachine z définissant un premier repère $(x, y, z)$ lié à l'arbre;
- un basculement du disque selon un premier angle $\varphi_{xd}(t)$ autour du premier axe du premier repère x, un deuxième repère $(x_1, y_1, z_1)$ étant obtenu par rotation du premier repère $(x, y, z)$ du premier angle $\varphi_{xd}(t)$ autour du premier axe du premier repère x;
- un basculement du disque selon un deuxième angle $\varphi_{yd}(t)$ autour du deuxième axe du deuxième repère $y_1$, un troisième repère $(x_2, y_2, z_2)$ étant obtenu par rotation du deuxième repère $(x_1, y_1, z_1)$ du deuxième angle $\varphi_{yd}(t)$ autour du deuxième axe du deuxième repère $y_1$;
- un positionnement angulaire de l'aube par rapport au deuxième axe du troisième repère $y_2$, ledit positionnement angulaire correspondant à une rotation selon un troisième angle $\alpha_j$ autour du troisième axe du troisième repère $z_2$, le repère lié au disque $(Xb, Yb, Zb)$ formant un quatrième repère obtenu par rotation du troisième repère $(x_2, y_2, z_2)$ du troisième angle $\alpha_j$ autour du troisième axe du troisième repère $z_2$;
- un fléchissement de l'aube à son sommet d'une troisième longueur $x_b(t)$ selon un premier axe $x_b$ d'un cinquième repère $(x_b, y_b, z_b)$ obtenu par rotation du quatrième repère $(Xb, Yb, Zb)$ d'un quatrième angle $\beta$ autour du deuxième axe du quatrième repère Yb;
- des translations du carter d'une quatrième longueur $x_c(t)$ et d'une cinquième longueur $y_c(t)$ selon les deux premiers axes du premier repère $(x,y)$ ;
- un basculement du carter d'un cinquième angle $\varphi_{xc}(t)$ autour du premier axe du premier repère x, un sixième repère $(x_{c1}, y_{c1}, z_{c1})$ étant obtenu par rotation du premier repère $(x, y, z)$ du cinquième angle $\varphi_{xc}(t)$ autour du premier axe du premier repère x;
- un basculement du carter d'un sixième angle $\varphi_{yc}(t)$ autour du deuxième axe du premier repère y, le repère $(x_c, y_c, z_c)$ lié au carter étant obtenu par rotation du sixième repère $(x_{c1}, y_{c1}, z_{c1})$ du sixième angle $\varphi_{yc}(t)$ autour du deuxième axe du premier repère y;
- une déformation radiale du carter d'une sixième longueur $u(a,t)$ par rapport à un rayon du carter Rc.

Ainsi, la cinématique en trois dimensions (3D) de l'ensemble des éléments de la turbomachine peut être prise en compte pour un calcul précis des possibilités de contact entre chaque aube et le carter.

Les coordonnées P' des extrémités du bord d'attaque et du bord de fuite de l'aube exprimées dans le repère lié au carter $(x_c, y_c, z_c)$ peuvent alors être exprimées à l'aide de la formule suivante :

$$P' = \mathbf{P}_{\varphi_{yc}} \mathbf{P}_{\varphi_{xc}} \left( \mathbf{P}_{\varphi_{xd}}^T \mathbf{P}_{\varphi_{yd}}^T \mathbf{P}_{\alpha_j}^T \left( P + \mathbf{P}_{\beta}^T \begin{Bmatrix} x_b(t) \\ 0 \\ 0 \end{Bmatrix} \right) + \begin{Bmatrix} x_d(t) - x_c(t) \\ y_d(t) - y_c(t) \\ 0 \end{Bmatrix} \right)$$

avec :

$\mathbf{P}_{\varphi_{xd}}$ la matrice de passage du premier repère $(x, y, z)$ au deuxième repère $(x_1, y_1, z_1)$, $\mathbf{P}_{\varphi_{yd}}$ la matrice de passage du deuxième repère $(x_1, y_1, z_1)$ au troisième repère $(x_2, y_2, z_2)$, $\mathbf{P}_{\varphi_{xc}}$ la matrice de passage du premier repère $(x, y, z)$ au sixième repère $(x_{c1}, y_{c1}, z_{c1})$ et $\mathbf{P}_{\varphi_{yc}}$ la matrice de passage du sixième repère $(x_{c1}, y_{c1}, z_{c1})$ au repère lié au carter $(x_c, y_c, z_c)$,

$\mathbf{P}_{\alpha_j}$ la matrice de passage liée au positionnement angulaire de l'aube sur le disque,

$\mathbf{P}_{\beta}$ la matrice de passage liée à l'orientation du fléchissement de l'aube en son sommet,

et,

$$\mathbf{P}_{\alpha_j} = \begin{bmatrix} \cos\alpha_j & \sin\alpha_j & 0 \\ -\sin\alpha_j & \cos\alpha_j & 0 \\ 0 & 0 & 1 \end{bmatrix} \; ; \; \mathbf{P}_{\beta} = \begin{bmatrix} \cos\beta & 0 & -\sin\beta \\ 0 & 1 & 0 \\ \sin\beta & 0 & \cos\beta \end{bmatrix}$$

$$\mathbf{P}_{\phi_{x_d}} = \begin{bmatrix} 1 & 0 & 0 \\ 0 & \cos\phi_{x_d} & \sin\phi_{x_d} \\ 0 & -\sin\phi_{x_d} & \cos\phi_{x_d} \end{bmatrix} \; ; \; \mathbf{P}_{\phi_{y_d}} = \begin{bmatrix} \cos\phi_{y_d} & 0 & -\sin\phi_{y_d} \\ 0 & 1 & 0 \\ \sin\phi_{y_d} & 0 & \cos\phi_{y_d} \end{bmatrix}$$

$$\mathbf{P}_{\phi_{x_c}} = \begin{bmatrix} 1 & 0 & 0 \\ 0 & \cos\phi_{x_c} & \sin\phi_{x_c} \\ 0 & -\sin\phi_{x_c} & \cos\phi_{x_c} \end{bmatrix} \; ; \; \mathbf{P}_{\phi_{y_c}} = \begin{bmatrix} \cos\phi_{y_c} & 0 & -\sin\phi_{y_c} \\ 0 & 1 & 0 \\ \sin\phi_{y_c} & 0 & \cos\phi_{y_c} \end{bmatrix}$$

Ceci permet d'obtenir une relation directe entre la position de l'extrémité d'une aube donnée par sa géométrie 3D et la position de cette même extrémité dans le repère lié au carter. Le calcul du jeu entre le carter et l'extrémité de l'aube est ainsi réduit à un calcul de distance minimale entre un point et la surface interne du carter définie dans le même repère.

La surface interne du carter étant considérée former un cône de révolution d'angle θ, de rayon de base Rb et de hauteur h, la distance g entre le carter et les extrémités du bord d'attaque et du bord de fuite de l'aube peut être calculée à l'aide de la formule suivante :

$$g(P) = \left( -\frac{R_b}{h} P'_z + R_b - \sqrt{P'^2_x + P'^2_y} + u(\alpha(P), t) \right) \cos\theta$$

avec

$$P' = \left\{ P'_x, P'_y, P'_z \right\}^T$$

Le calcul du jeu entre le carter et l'extrémité de l'aube est ainsi réduit à un calcul de distance minimale entre un point et un cône dans le repère lié au carter. L'expression de cette distance est directement fonction des coordonnées des extrémités de chaque aube P déduites de la géométrie 3D de la turbomachine et son calcul ne nécessite donc pas la résolution d'une équation intermédiaire supplémentaire. Le temps de calcul nécessaire pour déterminer cette distance est ainsi réduit.

Le calcul des pressions peut mettre en oeuvre une fonction de forme adaptée à l'extrémité de l'aube et au profil de jeu initial. Une telle variante permet de prendre en compte la géométrie 3D de l'extrémité de la zone de contact sans nécessiter une discrétisation.

Les pressions de contact peuvent être calculées le long d'une corde supposée rectiligne de longueur lc formant une extrémité de l'aube par une interpolation linéaire à partir des distances entre le carter et les extrémités supérieures du bord d'attaque et du bord de fuite de l'aube calculées.

Les pressions de contact normale $p_N$ et tangentielle $p_T$ en tout point de ladite corde peuvent être calculées à l'aide des formules suivantes :

$$p_N(c) = \frac{k_r}{l_c}(\zeta c + \eta) \text{ and } p_T(c) = \frac{k_t}{l_c}(\zeta c + \eta)$$

avec

$$\zeta = \frac{g(BF) - g(BA)}{l_c}$$

et

$$\eta = \frac{g(BF) + g(BA)}{2}$$

c représentant l'abscisse d'une position le long de ladite corde variant entre -lc/2 et +lc/2 et, $k_r$ et $k_t$ étant les raideurs normale et tangentielle au contact.

Les forces de réaction normale $F_N$ et tangentielle $F_T$ et les moments de réaction normal $M_N$ et tangentiel $M_T$ de réaction résultant du contact entre une aube et le carter peuvent alors être calculés à l'aide des formules suivantes :

$$F_N = \int_{c_1}^{c_2} p_N(c)dc \quad F_T = \int_{c_1}^{c_2} p_T(c)dc \quad M_N = \int_{c_1}^{c_2} c\, p_N(c)dc$$

$$M_T = \int_{c_1}^{c_2} c\, p_N(c)dc$$

$c_1$ et $c_2$ étant les abscisses minimum et maximum de l'ensemble des positions de la corde de l'aube en contact avec le carter.

Ceci permet de calculer les réactions de contact : forces et moments, à partir d'une distribution des pressions sur un sommet d'aube et ainsi de prendre en compte l'évolution de la zone de contact entre une aube et le carter.

Selon un deuxième aspect, l'invention concerne un produit programme d'ordinateur comprenant des instructions de code pour l'exécution d'un procédé de dimensionnement selon le premier aspect lorsque ce programme est exécuté par un processeur.

Selon un troisième aspect, l'invention concerne un dispositif de dimensionnement d'une turbomachine caractérisé en ce qu'il comprend des moyens de traitement de données comprenant :

- un module d'acquisition des coordonnées P des extrémités d'un bord d'attaque BA et d'un bord de fuite BF d'une aube d'une turbomachine dans un repère lié à un disque de la turbomachine (Xb, Yb, Zb) déterminées préalablement, ladite turbomachine comprenant un carter et ledit disque sur lequel est fixée au moins ladite aube, ledit carter entourant le disque et l'au moins une aube, ledit disque étant entrainé en rotation par un arbre autour d'un axe, dit axe de la turbomachine z;
- un module d'expression des coordonnées P' des extrémités supérieures du bord d'attaque et du bord de fuite de l'aube dans un repère lié au carter ($x_c$, $y_c$, $z_c$) à partir desdites coordonnées P acquises;

- un module de calcul de la distance g entre le carter et les extrémités du bord d'attaque et du bord de fuite de l'aube à partir des coordonnées P' des extrémités du bord d'attaque et du bord de fuite de l'aube dans le repère lié au carter ($x_c$, $y_c$, $z_c$);
- un module de calcul des pressions de contact entre l'aube et le carter normales et tangentielles le long de l'extrémité de l'aube à partir de la distance calculée g;
- un module de calcul des forces de réaction normale et tangentielle et des moments de réaction normal et tangentiel résultant du contact entre l'aube et le carter à partir des pressions calculées ;
- un module de dimensionnement de la turbomachine en fonction des distances, pressions, forces et moments calculés.

De tels produit programme d'ordinateur et moyens de traitement présentent les mêmes avantages que ceux évoqués pour le procédé selon le premier aspect.

**EP 3 152 406 B1**

PRESENTATION DES FIGURES

D'autres caractéristiques et avantages de la présente invention apparaîtront à la lecture de la description qui va suivre d'un mode de réalisation préférentiel. Cette description sera donnée en référence aux dessins annexés dans lesquels :

- la figure 1 illustre un exemple de turbomachine pour laquelle le procédé selon l'invention est mis en oeuvre ;
- la figure 2 représente des moyens de traitement de données pour la mise en oeuvre du procédé selon l'invention ;
- les figures 3a et 3b illustrent un exemple d'aube de turbomachine représentée respectivement en vue de face et en vue de profil pour laquelle le procédé selon l'invention est mis en oeuvre ;
- la figure 4 représente un exemple de schématisation d'aube de turbomachine pour laquelle le procédé selon l'invention est mis en oeuvre dans le repère lié au disque (Xb, Yb, Zb);
- les figures 5 à 9 illustrent les mouvements des différents éléments de la turbomachine pris en compte pour exprimer les coordonnées P' des extrémités du bord d'attaque et du bord de fuite de l'aube dans un repère lié au carter et représentent les différents repères utilisés associés ;
- les figures 10a et 10b illustrent le calcul des distances entre l'extrémité de l'aube et le carter ainsi que des pressions en tout point d'une corde rectiligne formant l'extrémité de l'aube par interpolation linéaire;
- la figure 11 est un diagramme schématisant une mise en oeuvre d'un procédé de dimensionnement selon l'invention.

DESCRIPTION DETAILLEE

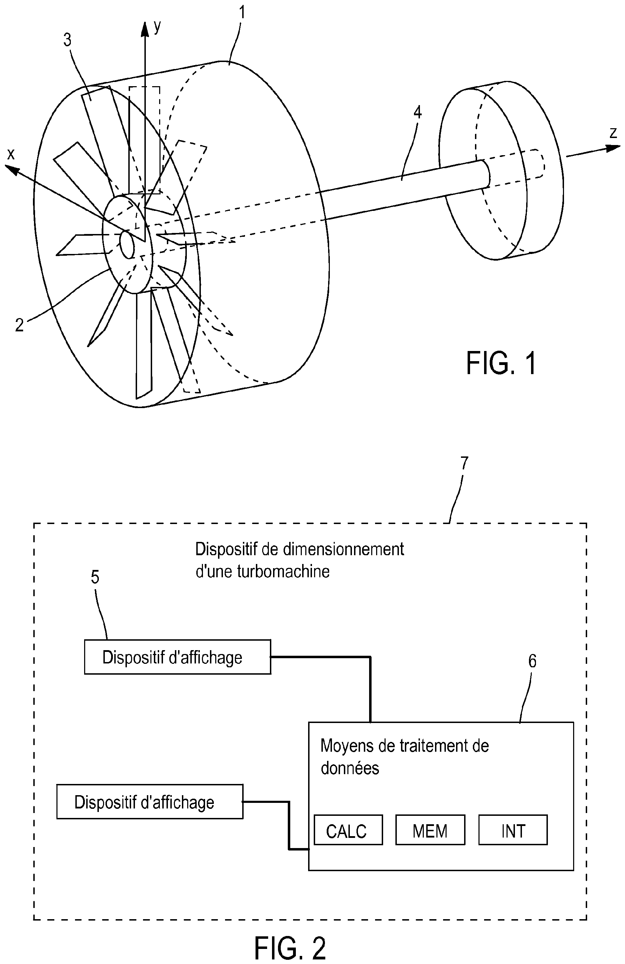

La présente invention concerne une mise en oeuvre d'un procédé de dimensionnement d'une turbomachine, telle que celle représentée sur la **figure 1,** comprenant un carter 1 et un disque 2 sur lequel est fixé au moins une aube 3, le carter entourant le disque et les aubes. Le disque et les aubes sont entrainés en rotation autour d'un axe z, dit axe de la turbomachine, par un arbre 4 s'étendant longitudinalement le long de l'axe z. Le premier repère (x,y,z) représenté en figure 1 dont les deux premiers axes x et y sont transverses à l'axe de la turbomachine z, est un repère tournant lié à l'arbre 4.

Le présent procédé est destiné de façon préférée au dimensionnement d'un turboréacteur d'aéronef mais il n'est limité ni à ce type de turbomachine ni au domaine des réacteurs. Ce procédé peut être mis en oeuvre pour le dimensionnement de toute machine tournante comportant des aubes en rotation à l'intérieur d'un carter, tel que des turbines de production d'électricité à eau, à gaz, à vapeur, des ventilateurs etc...

Il est par ailleurs destiné à être mis en oeuvre par un dispositif de dimensionnement d'une turbomachine 7 comprenant des moyens de traitement de données 6 représentés en **figure 2,** comportant des moyens de calcul CALC (calculateur), des moyens de stockage MEM (mémoire), une interface de saisie INT et au moins un dispositif d'affichage 5. De tels moyens de traitement sont pilotables par un opérateur.

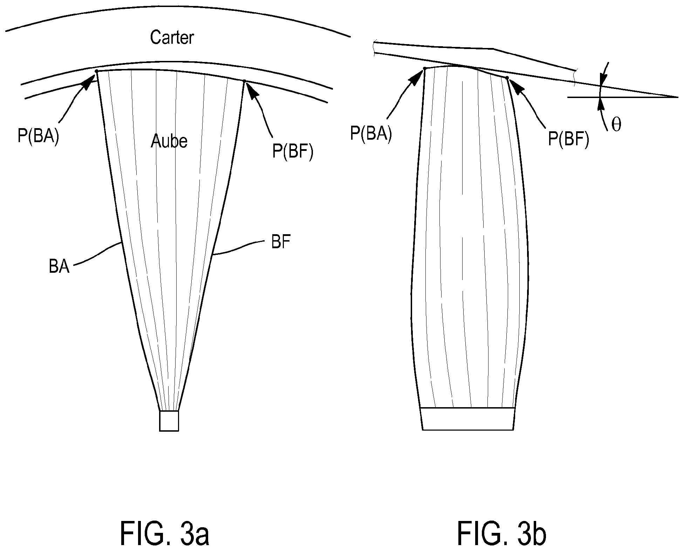

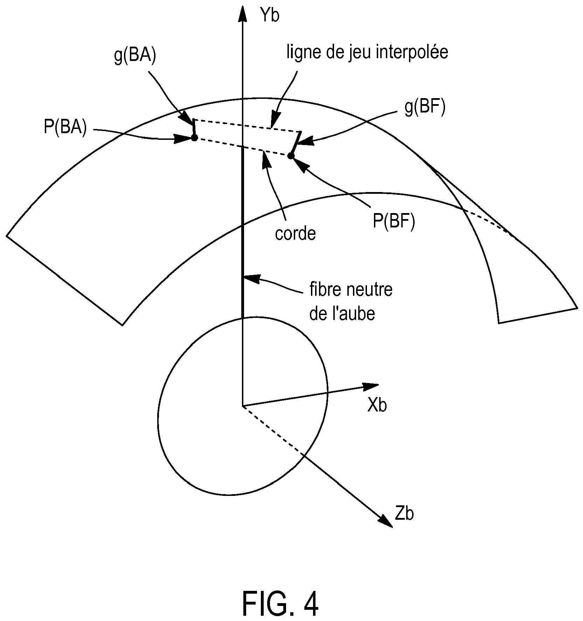

Une aube de turbomachine, représentée en vue de face en **figure 3a** et en vue de profil en **figure 3b,** présente un bord d'attaque BA et un bord de fuite BF. En notant (Xb, Yb, Zb) le repère lié au disque dans lequel cette aube est sensiblement verticale, c'est-à-dire tel que la fibre neutre de l'aube est alignée avec l'axe Yb, tel que représenté en **figure 4,** les coordonnées des extrémités au sommet d'aube du bord d'attaque et du bord de fuite de l'aube dans ce repère sont notées $P_{BA}$ et $P_{BF}$. Dans les paragraphes suivants, la notation P fera référence respectivement à $P_{BA}$ et à $P_{BF}$ lorsque le point traité est respectivement l'extrémité du bord d'attaque et l'extrémité du bord de fuite. Ces coordonnées sont acquises par les moyens de traitement de données 6 après avoir été déterminées préalablement à partir de la géométrie en trois dimensions (3D) de la turbomachine lors d'une première étape d'acquisition de coordonnées E1, telle que représentée en

**figure 11.**

Selon un mode de mise en oeuvre, le procédé propose ensuite :

- d'exprimer, à partir des coordonnées P acquises, les coordonnées P' des extrémités supérieures du bord d'attaque et du bord de fuite de l'aube dans un repère lié au carter ($x_c$, $y_c$, $z_c$),
- de calculer la distance g entre le carter et les extrémités du bord d'attaque et du bord de fuite de l'aube, à partir des coordonnées $P'_{BA}$ et $P'_{BF}$ des extrémités du bord d'attaque et du bord de fuite de l'aube dans le repère lié au carter ($x_c$, $y_c$, $z_c$),

- de calculer les pressions de contact entre l'aube et le carter normales $p_N$ et tangentielles $p_T$ le long de l'extrémité de l'aube à partir de la distance calculée g,
- de calculer les forces de réaction normale $F_N$ et tangentielle $F_T$ et les moments de réaction normal $M_N$ et tangentiel

$M_T$ résultant du contact entre l'aube et le carter à partir des pressions calculées $p_N$ et $p_T$,
- de dimensionner la turbomachine en fonction des distances, pressions, force et moment calculés.

Les coordonnées des extrémités du bord d'attaque et du bord de fuite de l'aube dans le repère lié au carter $(x_c, y_c, z_c)$ peuvent être exprimées en fonction d'un grand nombre de degrés de liberté d'éléments de la turbomachine dont le disque, le carter et les aubes par rapport au repère tournant $(x,y,z)$ représenté en **figure 1**. Ces degrés de liberté peuvent être choisis parmi les translations et basculements du disque et du carter, un fléchissement de l'aube à son sommet et une déformation radiale du carter.

Il est ainsi possible de dimensionner la machine tournante avec un calcul précis de l'espacement entre les extrémités d'aube et le carter, ainsi que des interactions en cas de contact, prenant en compte la cinématique 3D de l'ensemble des éléments de la turbomachine, sans avoir à utiliser une modélisation locale fine et couteuse, comme une modélisation 3D aux éléments finis.

Plus précisément, lors d'une deuxième étape d'expression de coordonnées E2, les coordonnées P' des extrémités du bord d'attaque et du bord de fuite de l'aube sont exprimées dans un repère lié au carter $(x_c, y_c, z_c)$ en prenant en compte des mouvements des éléments de la turbomachine parmi les degrés de liberté suivants des éléments de la turbomachine :

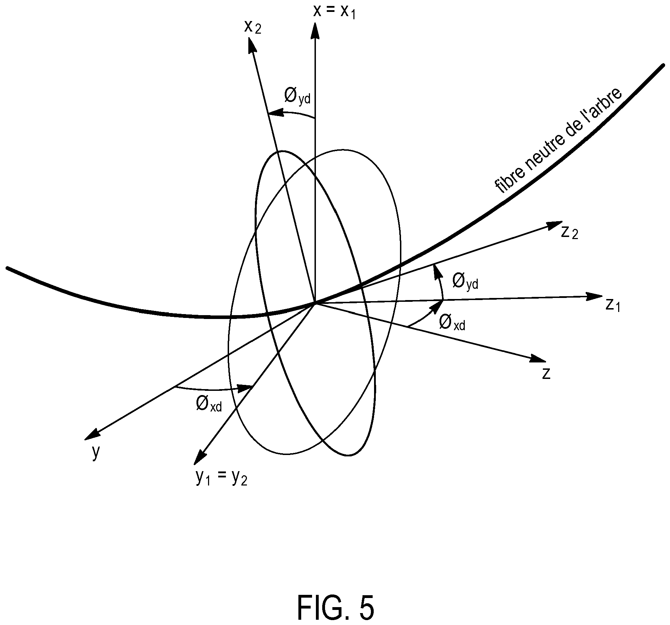

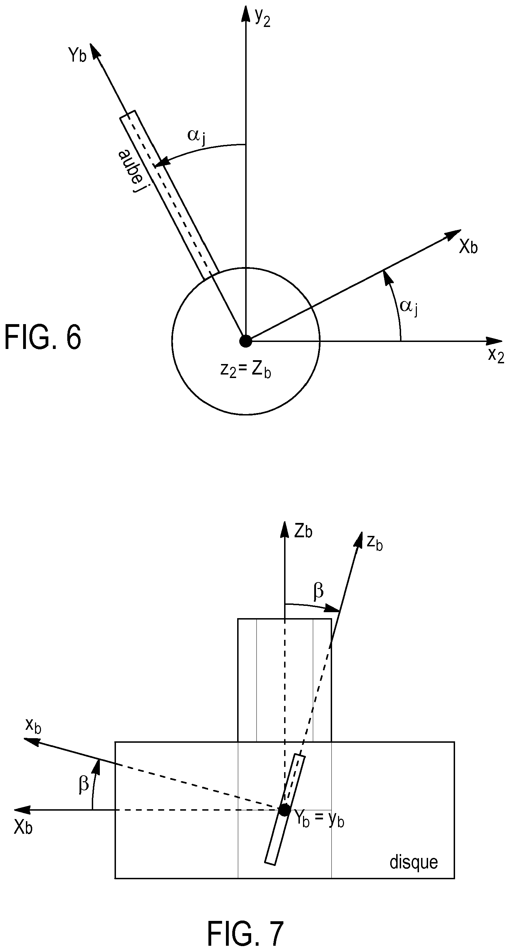

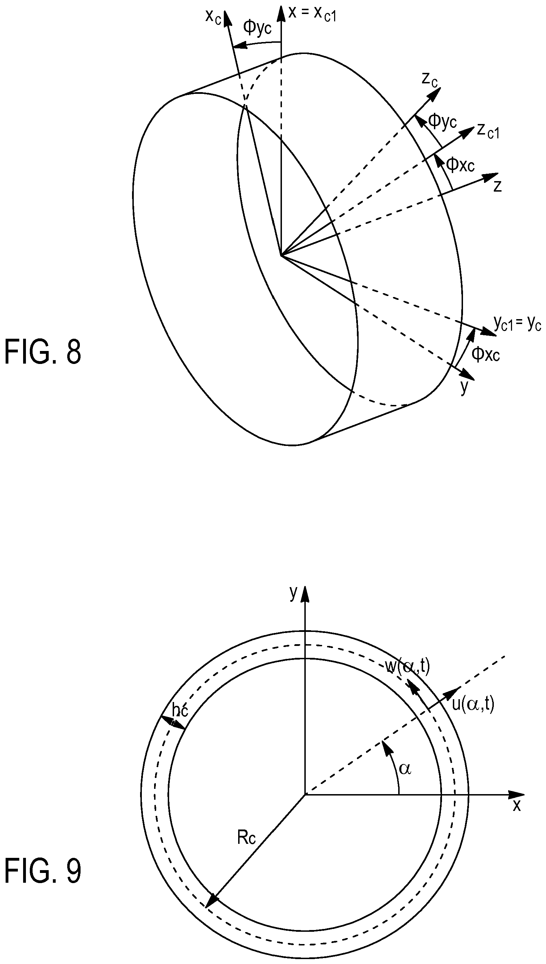

- des translations du disque d'une première longueur $x_d(t)$ et d'une deuxième longueur $y_d(t)$ selon les deux premiers axes x et y du premier repère $(x, y, z)$ ;
- un basculement du disque selon un premier angle $\varphi_{xd}(t)$ autour du premier axe du premier repère x, un deuxième repère $(x_1, y_1, z_1)$ étant obtenu par rotation du premier repère $(x, y, z)$ du premier angle $\varphi_{xd}(t)$ autour du premier axe du premier repère x, tel que représenté en **figure 5** ;
- un basculement du disque selon un deuxième angle $\varphi_{yd}(t)$ autour du deuxième axe du deuxième repère $y_1$, un troisième repère $(x_2, y_2, z_2)$ étant obtenu par rotation du deuxième repère $(x_1, y_1, z_1)$ du deuxième angle $\varphi_{yd}(t)$ autour du deuxième axe du deuxième repère $y_1$ tel que représenté en figure 5 ;
- un positionnement angulaire de l'aube par rapport au deuxième axe du troisième repère $y_2$, ledit positionnement angulaire correspondant à une rotation selon un troisième angle $\alpha_j$ autour du troisième axe du troisième repère $z_2$, le repère lié au disque $(Xb, Yb, Zb)$ formant un quatrième repère obtenu par rotation du troisième repère $(x_2, y_2, z_2)$ du troisième angle $\alpha_j$ autour du troisième axe du troisième repère $z_2$ tel que représenté en **figure 6** ;
- un fléchissement de l'aube à son sommet d'une troisième longueur $x_b(t)$ selon un premier axe $x_b$ d'un cinquième repère $(x_b, y_b, z_b)$ obtenu par rotation du quatrième repère $(Xb, Yb, Zb)$ d'un quatrième angle $\beta$ autour du deuxième axe du quatrième repère Yb tel que représenté en **figure 7** ;
- des translations du carter d'une quatrième longueur $x_c(t)$ et d'une cinquième longueur $y_c(t)$ selon les deux premiers axes du premier repère x et y ;
- un basculement du carter d'un cinquième angle $\varphi_{xc}(t)$ autour du premier axe du premier repère x, un sixième repère $(x_{c1}, y_{c1}, z_{c1})$ étant obtenu par rotation du premier repère $(x, y, z)$ du cinquième angle $\varphi_{xc}(t)$ autour du premier axe du premier repère x y tel que représenté en **figure 8** ;
- un basculement du carter d'un sixième angle $\varphi_{yc}(t)$ autour du deuxième axe du premier repère y, le repère $(x_c, y_c, z_c)$ lié au carter étant obtenu par rotation du sixième repère $(x_{c1}, y_{c1}, z_{c1})$ du sixième angle $\varphi_{yc}(t)$ autour du deuxième axe du premier repère y tel que représenté en **figure 8** ;
- une déformation radiale du carter d'une sixième longueur $u(\alpha, t)$ par rapport au rayon du carter Rc tel que représenté en **figure 9**.

La déformation tangentielle du carter $w(\alpha, t)$ est négligé. De plus, le carter est considéré dans sa section comme un anneau élastique inextensible. L'effet de l'épaisseur du carter hc sur les déformations de sa surface interne est négligé.

Ainsi, les coordonnées P' des extrémités du bord d'attaque et du bord de fuite de l'aube peuvent être exprimées dans le repère lié au carter $(x_c, y_c, z_c)$ par la formule suivante :

$$P' = \mathbf{P}_{\phi_{yc}} \mathbf{P}_{\phi_{xc}} \left( \mathbf{P}_{\phi_{xd}}^T \mathbf{P}_{\phi_{yd}}^T \mathbf{P}_{\alpha_j}^T \left( P + \mathbf{P}_{\beta}^T \begin{Bmatrix} x_b(t) \\ 0 \\ 0 \end{Bmatrix} \right) + \begin{Bmatrix} x_d(t) - x_c(t) \\ y_d(t) - y_c(t) \\ 0 \end{Bmatrix} \right)$$

Avec :

- $P_{\varphi_{xd}}$ la matrice de passage du premier repère $(x, y, z)$ au deuxième repère $(x_1, y_1, z_1)$, $P_{\varphi_{yd}}$ la matrice de passage du deuxième repère $(x_1, y_1, z_1)$ au troisième repère $(x_2, y_2, z_2)$, $P_{\varphi_{xc}}$ la matrice de passage du premier repère (x, y, z) au sixième repère ($x_{c1}$, $y_{c1}$, $z_{c1}$) et $P_{\varphi yc}$ la matrice de passage du sixième repère ($x_{c1}$, $y_{c1}$, $z_{c1}$) au repère lié au carter ($x_c$, $y_c$, $z_c$),

- Paj la matrice de passage liée au positionnement angulaire de l'aube sur le disque,
- P$\beta$ la matrice de passage liée à l'orientation du fléchissement de l'aube en son sommet.

Les matrices de passage peuvent être définies comme suit :

$$\mathbf{P}_{\alpha_j} = \begin{bmatrix} \cos\alpha_j & \sin\alpha_j & 0 \\ -\sin\alpha_j & \cos\alpha_j & 0 \\ 0 & 0 & 1 \end{bmatrix} \; ; \; \mathbf{P}_{\beta} = \begin{bmatrix} \cos\beta & 0 & -\sin\beta \\ 0 & 1 & 0 \\ \sin\beta & 0 & \cos\beta \end{bmatrix}$$

$$\mathbf{P}_{\phi_{x_d}} = \begin{bmatrix} 1 & 0 & 0 \\ 0 & \cos\phi_{x_d} & \sin\phi_{x_d} \\ 0 & -\sin\phi_{x_d} & \cos\phi_{x_d} \end{bmatrix} \; ; \; \mathbf{P}_{\phi_{y_d}} = \begin{bmatrix} \cos\phi_{y_d} & 0 & -\sin\phi_{y_d} \\ 0 & 1 & 0 \\ \sin\phi_{y_d} & 0 & \cos\phi_{y_d} \end{bmatrix}$$

$$\mathbf{P}_{\phi_{x_c}} = \begin{bmatrix} 1 & 0 & 0 \\ 0 & \cos\phi_{x_c} & \sin\phi_{x_c} \\ 0 & -\sin\phi_{x_c} & \cos\phi_{x_c} \end{bmatrix} \; ; \; \mathbf{P}_{\phi_{y_c}} = \begin{bmatrix} \cos\phi_{y_c} & 0 & -\sin\phi_{y_c} \\ 0 & 1 & 0 \\ \sin\phi_{y_c} & 0 & \cos\phi_{y_c} \end{bmatrix}$$

Lors d'une première étape de calcul E3, la distance entre le carter et les extrémités du bord d'attaque et du bord de fuite de l'aube est calculée. En supposant que la surface interne du carter forme un cône de révolution d'angle θ, de rayon de base Rb et de hauteur h acquis lors de l'acquisition des coordonnées P des extrémités du bord d'attaque, ledit cône étant représenté en figure 3, cette distance peut s'exprimer à partir des coordonnées P selon la formule suivante :

$$g(P) = \left( -\frac{R_b}{h} P_z' + R_b - \sqrt{P_x'^2 + P_y'^2} + u(\alpha(P), t) \right) \cos\theta$$

avec

$$P' = \left\{ P_x', P_y', P_z' \right\}^T$$

L'expression des coordonnées des extrémités des bords d'attaque et de fuite de l'aube dans le repère lié au carter ($x_c$, $y_c$, $z_c$) représenté en figure 8 permet ainsi de transformer le calcul du jeu entre une aube et le carter en un simple calcul de distance entre un point et cône dans un repère.

La modélisation mise en oeuvre permet ainsi de calculer de manière précise la distance entre les extrémités de chaque aube et le carter, en tenant compte d'un nombre important de degrés de libertés de l'ensemble des éléments de la turbomachine, sans pour autant devoir faire appel à une couteuse discrétisation telle qu'un modèle aux éléments finis. L'expression de cette distance est directement fonction des coordonnées des extrémités de chaque aube P déduites de la géométrie 3D de la turbomachine et son calcul ne nécessite donc pas la résolution d'une équation intermédiaire supplémentaire. Le temps de calcul nécessaire pour déterminer cette distance est ainsi réduit.

Lors d'une deuxième étape de calcul E4, en cas de contact entre une aube et le carter, les pressions de contact normale et tangentielle peuvent être calculées le long de l'extrémité de l'aube à partir des distances calculées lors de la première étape de calcul E3.

Une fonction de forme adaptée à l'extrémité de l'aube et au profil de jeu initial peut être utilisée afin de déterminer précisément les distances entre l'aube et le carter en tout point de la corde de l'aube, ainsi que les pressions de contact associées. Ce profil de jeu initial peut être déterminé à partir de la forme de l'extrémité de l'aube et de la forme de la surface interne du carter en regard de cette extrémité, lors de la première étape d'acquisition E1, à partir de la géométrie en trois dimensions (3D) de la turbomachine.

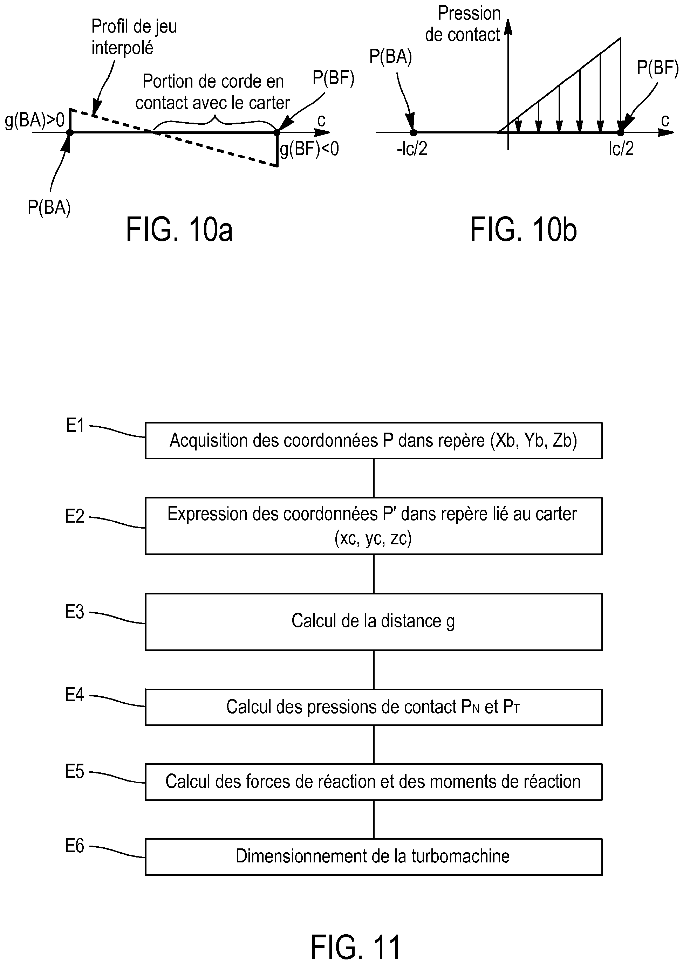

Dans une première variante, la fonction de forme utilisée peut être linéaire. La distance entre l'extrémité de l'aube et le carter peut être obtenue en tout point d'une corde rectiligne de longueur lc formant l'extrémité supérieure de l'aube par une interpolation linéaire à partir des distances calculées au niveau du bord d'attaque et du bord de fuite, comme représenté en **figure 10a,** et les pressions normale $p_N$ et tangentielle $p_T$ en tout point de cette corde peuvent être exprimées par les formules suivantes :

$$p_N(c) = \frac{k_r}{l_c}(\zeta c + \eta) \text{ and } p_T(c) = \frac{k_t}{l_c}(\zeta c + \eta)$$

avec

$$\zeta = \frac{g(BF) - g(BA)}{l_c}$$

et

$$\eta = \frac{g(BF) + g(BA)}{2}$$

c variant le long de la corde entre -lc/2 et +lc/2, $k_r$ et $k_t$ étant les raideurs normale et tangentielle au contact, $\eta$ représentant la distance moyenne entre l'aube et le carter, et $\zeta c + \eta$ représentant l'écart entre l'aube et le carter à la position c de la corde obtenu par interpolation linéaire.

Aux positions pour lesquelles la distance entre l'aube et le carter est positive, correspondant alors à une absence de contact, les pressions normale et tangentielle à prendre en compte sont nulles, comme représenté en **figure 10b.**

Alternativement, une fonction de forme représentant de manière plus réaliste la forme de l'extrémité de l'aube et du profil de jeu initial peut être utilisée afin de déterminer précisément les distances entre l'aube et le carter en tout point de la corde d'une aube dont l'extrémité et le profil de jeu initial n'est pas rectiligne, ainsi que les pressions de contact associées. A titre d'exemple, une fonction de forme polynomiale peut être employée, par exemple d'ordre 2 sous la forme $W(c) = (a_2 {}^* c^2 + a_1 {}^* c + a0)$ ou d'ordre 3 sous la forme $W(c) = (a_3 {}^* c^3 + a_2 {}^* c^2 + a_1 {}^* c + a_0)$, les coefficients a0, a1, a2 et a3 étant dépendants des jeux calculés aux extrémités du bord d'attaque et du bord de fuite de l'aube et du profil de jeu initial défini lors de la première étape d'acquisition E1. Les pressions de contact normale et tangentielle entre l'aube et le carter peuvent alors s'exprimer en fonction d'une telle fonction de forme selon les expressions suivantes :

$$p_N(c) = \frac{k_r}{l_c} W(c) \text{ et } p_T(c) = \frac{k_t}{l_c} W(c).$$

Ainsi, les pressions de contact peuvent être calculées en tout point de l'extrémité de l'aube en cas de contact avec le carter, en prenant en compte la géométrie 3D de la zone de contact, sans avoir à discrétiser la géométrie de l'aube ni à utiliser une géométrie trop simplifiée non représentative de la géométrie réelle de l'aube.

Lors d'une troisième étape de calcul E5, les forces de réaction normale $F_N$ et tangentielle $F_T$ et les moments de réaction normal $M_N$ et tangentiel $M_T$ de réaction résultant du contact entre une aube et le carter sont calculés. Ils peuvent être exprimés à l'aide des formules suivantes :

$$F_N = \int_{c_1}^{c_2} p_N(c) dc \quad F_T = \int_{c_1}^{c_2} p_T(c) dc \quad M_N = \int_{c_1}^{c_2} c\, p_N(c) dc$$

$$M_T = \int_{c_1}^{c_2} c\, p_N(c)\, dc$$

avec c1 et c2 définissant les limites de contact entre l'aube et le carter :

- c1= -lc/2 et c2= lc/2 si les distances entre l'aube et le carter sont négatives pour le bord de fuite et le bord d'attaque. Il y a alors contact tout le long de la corde.
- c1= -lc/2 et c2= - $\eta/\varsigma$ si la distance entre l'aube et le carter est négative au niveau du bord d'attaque mais positive au niveau du bord de fuite. Il y a alors contact sur une partie de la corde de l'aube, du côté du bord d'attaque.
- c1= $\eta/\varsigma$ et c2= lc/2 si la distance entre l'aube et le carter est négative au niveau du bord de fuite mais positive au niveau du bord d'attaque. Il y a alors contact sur une partie de la corde de l'aube, du côté du bord de fuite.

Dans les formules présentées, les efforts normaux sont proportionnels à la pénétration entre les solides et les efforts de frottement sont obtenus grâce à la loi de Coulomb.

Ainsi les forces et moments de réaction peuvent être calculés en tout point de l'extrémité de l'aube en cas de contact avec le carter, sans avoir à discrétiser la géométrie de l'aube ni à utiliser une géométrie simplifiée non représentative de la géométrie réelle de l'aube. Un tel modèle permet de prendre en compte l'évolution de la distribution des pressions de contact sur la corde. Le contact peut être initié à l'une des extrémités de la corde puis la zone de contact peut évoluer jusqu'à ce que l'aube touche le carter sur toute sa corde. Les étapes décrites ci-dessus permettent de calculer une distribution des efforts réaliste, tenant compte de l'évolution de la zone de contact.

Lors d'une étape de dimensionnement E6, les résultats des calculs des étapes précédentes sont utilisés pour réaliser le dimensionnement de la turbomachine.

Selon un premier exemple, les résultats de la première étape de calcul E3 sont utilisés pour réaliser une détection de contact. Les résultats de tels calculs pour différentes vitesses de rotation et en supposant un certain déséquilibrage de la turbomachine peuvent être utilisés pour déterminer les déplacements maximums de l'extrémité d'aube lors du fonctionnement du moteur. Toutes les plages de vitesses de rotation pour lesquelles l'espacement initial au repos entre l'extrémité d'aube et le carter est inférieur au déplacement maximal calculé présenteront un risque de contact entre une aube et le carter de la turbomachine.

Selon un deuxième exemple, les résultats des calculs des forces et moments de réaction lors de la troisième étape de calcul E5 peuvent être projetés sur les degrés de liberté du modèle pour être introduit dans le système d'équation décrivant les mouvements de la turbomachine. La résolution de cette équation avec contact peut alors permettre de statuer sur les efforts à encaisser par la turbomachine et l'apparition de régime de fonctionnement instable, potentiellement dangereux pour la turbomachine. L'équation du mouvement avec contact peut être résolue de plusieurs manières. Une analyse de stabilité de la turbomachine peut être réalisée en supposant un contact permanent d'au moins une aube avec le carter de la turbomachine. Les efforts de contacts calculés lors de l'étape E5 et projetés sur les degrés de liberté du modèle, sont alors linéarisés et appliqués de manière permanente à un système d'équation décrivant le mouvement des éléments de la turbomachine. Une analyse de stabilité peut être menée afin de prédire pour différentes vitesses de rotation si l'introduction d'une perturbation peut provoquer l'apparition d'un régime de fonctionnement instable, potentiellement dangereux pour la turbomachine.

Enfin, selon un troisième exemple, les résultats des calculs de distances, forces et moments obtenus lors des différentes étapes précédentes peuvent être employés au sein d'un calcul transitoire pour déterminer à chaque pas de temps du calcul le risque de contact entre une aube et le carter et les forces et moments de réaction associés le cas échéant. Un tel calcul pourra être mis en oeuvre par exemple par la méthode d'intégration temporelle dite des différences finies centrées. Ainsi il est possible de réaliser un calcul d'un régime transitoire résultant d'une perturbation prenant en compte à chaque instant du transitoire la possibilité d'un contact et les réactions résultant d'un tel contact. L'évolution des forces de réaction au cours du transitoire permet de déterminer les efforts à encaisser par la turbomachine et une éventuelle instabilité du régime de fonctionnement de la turbomachine résultant de la perturbation à l'origine du transitoire.

Si l'une de ces analyses fait apparaître un risque inacceptable pour la turbomachine, l'opérateur mettant en oeuvre un tel procédé à l'aide des moyens de traitements peut alors modifier une caractéristique de la turbomachine afin d'améliorer son dimensionnement, pour la rendre plus résistante à une perturbation par exemple. L'opérateur peut par exemple modifier les caractéristiques géométriques des aubes, du disque ou du carter de la turbomachine, interdire une certaine plage de vitesses de rotation présentant un risque trop important d'endommagement, modifier le matériau utilisé pour un des éléments de la turbomachine de façon à diminuer la flexibilité de cet élément...

Ainsi, il est possible de dimensionner de manière optimisée une turbomachine, de façon à limiter les risques d'endommagement en cas de contact entre les aubes et le carter de la turbomachine, en minimisant l'impact sur ses performances grâce à une modélisation fidèle de la géométrie et de la dynamique des éléments de la turbomachine, sans accroître la quantité de ressources informatiques consommées.

Le dispositif de dimensionnement d'une turbomachine représenté sur la figure 2 pour la mise en oeuvre du procédé de dimensionnement comprend des moyens de traitement de données 6 comprenant :

- un module d'acquisition des coordonnées P des extrémités d'un bord d'attaque BA et d'un bord de fuite BF d'une aube d'une turbomachine dans un repère lié à un disque de la turbomachine (Xb, Yb, Zb) déterminées préalablement, ladite turbomachine comprenant un carter et ledit disque sur lequel est fixé au moins ladite aube, ledit carter entourant le disque et l'au moins une aube, ledit disque étant entrainé en rotation par un arbre autour d'un axe, dit axe de la turbomachine z;
- un module d'expression des coordonnées P' des extrémités du bord d'attaque et du bord de fuite de l'aube dans un repère lié au carter ($x_c$, $y_c$, $z_c$) à partir desdites coordonnées acquises;
- un module de calcul de la distance g entre le carter et les extrémités du bord d'attaque et du bord de fuite de l'aube à partir des coordonnées P' des extrémités du bord d'attaque et du bord de fuite de l'aube dans le repère lié au carter ($x_c$, $y_c$, $z_c$);
- un module de calcul des pressions de contact entre l'aube et le carter normales $p_N$ et tangentielles $p_T$ le long de l'extrémité de l'aube à partir de la distance calculée g ;
- un module de calcul des forces de réaction normale $F_N$ et tangentielle $F_T$ et des moments de réaction normal $M_N$ et tangentiel $M_T$ résultant du contact entre l'aube et le carter à partir des pressions calculées ;
- un module de dimensionnement de la turbomachine en fonction des distances, pressions, forces et moments calculés.

## Revendications

1. Procédé de dimensionnement d'une turbomachine comprenant un carter (1) et un disque (2) sur lequel est fixée au moins une aube (3), ledit carter entourant le disque et l'au moins une aube, ledit disque (2) étant entrainé en rotation par un arbre (4) autour d'un axe, dit axe de la turbomachine (z), et ladite aube comprenant un bord d'attaque (BA) et un bord de fuite (BF), ledit procédé étant **caractérisé en ce qu'**il comprend la mise en oeuvre par des moyens de traitement de données (6) d'étapes de :

   - acquisition (E1) des coordonnées (P) des extrémités du bord d'attaque et du bord de fuite de l'aube dans un repère lié au disque (Xb, Yb, Zb) déterminées préalablement;
   - à partir desdites coordonnées acquises (P), expression (E2) des coordonnées (P') des extrémités supérieures du bord d'attaque et du bord de fuite de l'aube dans un repère lié au carter ($x_c$, $y_c$, $z_c$);
   - calcul (E3) de la distance (g) entre le carter et les extrémités du bord d'attaque et du bord de fuite de l'aube à partir des coordonnées (P') des extrémités du bord d'attaque et du bord de fuite de l'aube dans le repère lié au carter ($x_c$, $y_c$, $z_c$);
   - calcul (E4) des pressions de contact entre l'aube et le carter normales ($p_N$) et tangentielles ($p_T$) le long de l'extrémité de l'aube à partir de la distance calculée (g) ;
   - calcul (E5) des forces de réaction normale ($F_N$) et tangentielle ($F_T$) et des moments de réaction normal ($M_N$) et tangentiel ($M_T$) résultant du contact entre l'aube et le carter à partir des pressions calculées ;
   - dimensionnement (E6) de la turbomachine en fonction des distances, pressions, forces et moments calculés.

2. Procédé selon la revendication 1, dans lequel les coordonnées des extrémités du bord d'attaque et du bord de fuite de l'aube dans le repère lié au carter ($x_c$, $y_c$, $z_c$) sont exprimées (E2) en fonction de degrés de liberté du disque, du carter et de l'aube.

3. Procédé selon la revendication 2, dans lequel lesdits degrés de liberté sont parmi des translations et basculements du disque et du carter, un fléchissement de l'aube à son sommet et une déformation radiale du carter.

4. Procédé selon la revendication 2 ou 3, dans lequel lesdits degrés de liberté sont parmi :

   - des translations du disque d'une première longueur ($x_d(t)$) et d'une deuxième longueur ($y_d(t)$) selon deux axes (x, y) transverses à l'axe de la turbomachine (z), les deux axes transverses (x,y) et l'axe de la turbomachine (z) définissant un premier repère (x, y, z) lié à l'arbre;
   - un basculement du disque selon un premier angle ($\varphi_{xd}(t)$) autour du premier axe du premier repère (x), un deuxième repère ($x_1$, $y_1$, $z_1$) étant obtenu par rotation du premier repère (x, y, z) du premier angle ($\varphi_{xd}(t)$) autour du premier axe du premier repère (x) ;
   - un basculement du disque selon un deuxième angle ($\varphi_{yd}(t)$) autour du deuxième axe du deuxième repère ($y_1$),

un troisième repère ($x_2$, $y_2$, $z_2$) étant obtenu par rotation du deuxième repère ($x_1$, $y_1$, $z_1$) du deuxième angle ($\varphi_{yd}(t)$) autour du deuxième axe du deuxième repère ($y_1$) ;

- un positionnement angulaire de l'aube par rapport au deuxième axe du troisième repère ($y_2$), ledit positionnement angulaire correspondant à une rotation selon un troisième angle ($\alpha_j$) autour du troisième axe du troisième repère ($z_2$), le repère lié au disque ($Xb$, $Yb$, $Zb$) formant un quatrième repère obtenu par rotation du troisième repère ($x_2$, $y_2$, $z_2$) du troisième angle ($\alpha_j$) autour du troisième axe du troisième repère ($z_2$);

- un fléchissement de l'aube à son sommet d'une troisième longueur ($x_b(t)$) selon un premier axe ($x_b$) d'un cinquième repère ($x_b$,$y_b$,$z_b$) obtenu par rotation du quatrième repère ($Xb$, $Yb$, $Zb$) d'un quatrième angle ($\beta$) autour du deuxième axe du quatrième repère ($Yb$) ;

- des translations du carter d'une quatrième longueur ($x_c(t)$) et d'une cinquième longueur ($y_c(t)$) selon les deux premiers axes du premier repère (x,y) ;

- un basculement du carter d'un cinquième angle ($\varphi_{xc}(t)$) autour du premier axe du premier repère (x), un sixième repère ($x_{c1}$, $y_{c1}$, $z_{c1}$) étant obtenu par rotation du premier repère (x, y, z) du cinquième angle ($\varphi_{xc}(t)$) autour du premier axe du premier repère (x);

- un basculement du carter d'un sixième angle $\varphi_{yc}(t)$ autour du deuxième axe du premier repère y, le repère ($x_c$, $y_c$, $z_c$) lié au carter étant obtenu par rotation du sixième repère ($x_{c1}$, $y_{c1}$, $z_{c1}$) du sixième angle ($\varphi_{yc}(t)$) autour du deuxième axe du premier repère (y);

- une déformation radiale du carter d'une sixième longueur ($u(\alpha,t)$) par rapport à un rayon du carter ($Rc$).

5. Procédé selon la revendication 4, dans lequel les coordonnées P' des extrémités du bord d'attaque et du bord de fuite de l'aube exprimées dans le repère lié au carter ($x_c$, $y_c$, $z_c$) sont exprimées (E2) à l'aide de la formule suivante :

$$P' = \mathbf{P}_{\phi_{yc}} \mathbf{P}_{\phi_{xc}} \left( \mathbf{P}_{\phi_{xd}}^T \mathbf{P}_{\phi_{yd}}^T \mathbf{P}_{\alpha_j}^T \left( P + \mathbf{P}_{\beta}^T \begin{Bmatrix} x_b(t) \\ 0 \\ 0 \end{Bmatrix} \right) + \begin{Bmatrix} x_d(t) - x_c(t) \\ y_d(t) - y_c(t) \\ 0 \end{Bmatrix} \right)$$

Avec :

$P_{\varphi_{xd}}$ la matrice de passage du premier repère (x, y, z) au deuxième repère ($x_1$, $y_1$, $z_1$), $P_{\varphi_{yd}}$ la matrice de passage du deuxième repère ($x_1$, $y_1$, $z_1$) au troisième repère ($x_2$, $y_2$, $z_2$), $P_{\varphi_{xc}}$ la matrice de passage du premier repère (x, y, z) au sixième repère ($x_{c1}$, $y_{c1}$, $z_{c1}$) et $P_{\varphi_{yc}}$ la matrice de passage du sixième repère ($x_{c1}$, $y_{c1}$, $z_{c1}$) au repère lié au carter ($x_c$, $y_c$, $z_c$),

Paj la matrice de passage liée au positionnement angulaire de l'aube sur le disque,

Pβ la matrice de passage liée à l'orientation du fléchissement de l'aube en son sommet,

et

$$\mathbf{P}_{\alpha_j} = \begin{bmatrix} \cos \alpha_j & \sin \alpha_j & 0 \\ -\sin \alpha_j & \cos \alpha_j & 0 \\ 0 & 0 & 1 \end{bmatrix} \; ; \; \mathbf{P}_{\beta} = \begin{bmatrix} \cos \beta & 0 & -\sin \beta \\ 0 & 1 & 0 \\ \sin \beta & 0 & \cos \beta \end{bmatrix}$$

$$\mathbf{P}_{\phi_{xd}} = \begin{bmatrix} 1 & 0 & 0 \\ 0 & \cos \phi_{xd} & \sin \phi_{xd} \\ 0 & -\sin \phi_{xd} & \cos \phi_{xd} \end{bmatrix} \; ; \; \mathbf{P}_{\phi_{yd}} = \begin{bmatrix} \cos \phi_{yd} & 0 & -\sin \phi_{yd} \\ 0 & 1 & 0 \\ \sin \phi_{yd} & 0 & \cos \phi_{yd} \end{bmatrix}$$

$$\mathbf{P}_{\phi_{xc}} = \begin{bmatrix} 1 & 0 & 0 \\ 0 & \cos \phi_{xc} & \sin \phi_{xc} \\ 0 & -\sin \phi_{xc} & \cos \phi_{xc} \end{bmatrix} \; ; \; \mathbf{P}_{\phi_{yc}} = \begin{bmatrix} \cos \phi_{yc} & 0 & -\sin \phi_{yc} \\ 0 & 1 & 0 \\ \sin \phi_{yc} & 0 & \cos \phi_{yc} \end{bmatrix}$$

6. Procédé selon la revendication 5, dans lequel la surface interne du carter étant considérée former un cône de révolution d'angle θ, de rayon de base Rb et de hauteur h, la distance g entre le carter et les extrémités du bord d'attaque et du bord de fuite de l'aube est calculée (E3) à l'aide de la formule suivante :

$$g(P) = \left( -\frac{R_b}{h} P'_z + R_b - \sqrt{P'^2_x + P'^2_y} + u(\alpha(P), t) \right) \cos\theta$$

avec

$$P' = \left\{ P'_x, P'_y, P'_z \right\}^T$$

7. Procédé selon l'une des revendications 1 à 6, dans lequel le calcul des pressions (E4) met en oeuvre une fonction de forme adaptée à l'extrémité de l'aube et au profil de jeu initial.

8. Procédé selon l'une des revendications précédentes, dans lequel les pressions de contact sont calculées (E4) le long d'une corde supposée rectiligne de longueur lc formant une extrémité de l'aube par une interpolation linéaire à partir des distances entre le carter et les extrémités supérieures du bord d'attaque et du bord de fuite de l'aube calculées.

9. Procédé selon la revendication 8, dans lequel les pressions de contact normale $p_N$ et tangentielle $p_T$ en tout point de ladite corde sont calculées (E4) à l'aide des formules suivantes :

$$p_N(c) = \frac{k_r}{l_c}(\zeta c + \eta) \text{ and } p_T(c) = \frac{k_t}{l_c}(\zeta c + \eta)$$

avec

$$\zeta = \frac{g(BF) - g(BA)}{l_c}$$

et

$$\eta = \frac{g(BF) + g(BA)}{2}$$

c représentant l'abscisse d'une position le long de ladite corde variant entre -lc/2 et +lc/2 et, $k_r$ et $k_t$ étant les raideurs normale et tangentielle au contact.

10. Procédé selon la revendication 9, dans lequel les forces de réaction normale $F_N$ et tangentielle $F_T$ et les moments de réaction normal $M_N$ et tangentiel $M_T$ de réaction résultant du contact entre une aube et le carter sont calculés (E5) à l'aide des formules suivantes :

$$F_N = \int_{c_1}^{c_2} p_N(c)dc \quad F_T = \int_{c_1}^{c_2} p_T(c)dc \quad M_N = \int_{c_1}^{c_2} c\, p_N(c)dc$$

$$M_T = \int_{c_1}^{c_2} c\, p_N(c)dc$$

c1 et c2 étant les abscisses minimum et maximum de l'ensemble des positions de la corde de l'aube en contact avec le carter.

**11.** Produit programme d'ordinateur comprenant des instructions de code pour l'exécution d'un procédé de dimensionnement selon l'une quelconque des revendications précédentes lorsque ce programme est exécuté par un processeur.

**12.** Dispositif de dimensionnement d'une turbomachine (7) **caractérisé en ce qu'**il comprend des moyens de traitement de données (6) comprenant :

- un module d'acquisition des coordonnées (P) des extrémités d'un bord d'attaque (BA) et d'un bord de fuite (BF) d'une aube d'une turbomachine dans un repère lié à un disque de la turbomachine (Xb, Yb, Zb) déterminées préalablement, ladite turbomachine comprenant un carter et ledit disque sur lequel est fixée au moins ladite aube, ledit carter entourant le disque et l'au moins une aube, ledit disque étant entrainé en rotation par un arbre autour d'un axe, dit axe de la turbomachine (z);
- un module d'expression des coordonnées (P') des extrémités supérieures du bord d'attaque et du bord de fuite de l'aube dans un repère lié au carter ($x_c$, $y_c$, $z_c$) à partir desdites coordonnées acquises;
- un module de calcul de la distance (g) entre le carter et les extrémités du bord d'attaque et du bord de fuite de l'aube à partir des coordonnées (P') des extrémités du bord d'attaque et du bord de fuite de l'aube dans le repère lié au carter ($x_c$, $y_c$, $z_c$);
- un module de calcul des pressions de contact entre l'aube et le carter normales ($p_N$) et tangentielles ($p_T$) le long de l'extrémité de l'aube à partir de la distance calculée (g) ;
- un module de calcul des forces de réaction normale ($F_N$) et tangentielle ($F_T$) et des moments de réaction normal ($M_N$) et tangentiel ($M_T$) résultant du contact entre l'aube et le carter à partir des pressions calculées ;
- un module de dimensionnement de la turbomachine en fonction des distances, pressions, forces et moments calculés.

**Patentansprüche**

**1.** Verfahren zur Dimensionierung einer Turbomaschine umfassend ein Gehäuse (1) und eine Scheibe (2), an der zumindest eine Schaufel (3) befestigt ist, wobei das Gehäuse die Scheibe und die zumindest eine Schaufel umgibt und die Scheibe (2) von einer Welle (4) um eine Achse, die Achse der Turbomaschine (z), in Drehung versetzt wird, und die Schaufel eine Vorderkante (BA) und eine Hinterkante (BF) aufweist, wobei das Verfahren **dadurch gekennzeichnet ist, dass** es die Durchführung der folgenden Schritte durch Datenverarbeitungsmittel (6) umfasst:

- Erfassung (E1) der Koordinaten (P) der Enden der Vorder- und der Hinterkante der Schaufel in einer Skala, die mit der zuvor ermittelten Scheibe (Xb, Yb, Zb) verknüpft ist;
- Ausgehend von den erfassten Koordinaten (P), Ausdruck (E2) der Koordinaten (P') der oberen Enden der Vorder- und der Hinterkante der Schaufel in einer mit dem Gehäuse ($x_c$, $Y_c$, $z_c$) verknüpften Skala;
- Berechnung (E3) des Abstands (g) zwischen dem Gehäuse und den Enden der Vorder- und der Hinterkante der Schaufel ausgehend von den Koordinaten (P') der Enden der Vorder- und der Hinterkante der Schaufel in der mit dem Gehäuse ($x_c$, $y_c$, $z_c$) verknüpften Skala;
- Berechnung (E4) des normalen ($p_N$) und des tangentialen ($p_T$) Anpressdrucks zwischen der Schaufel und dem Gehäuse entlang dem Schaufelende ausgehend vom berechneten Abstand (g);
- Berechnung (E5) der normalen ($F_N$) und tangentialen ($F_T$) Reaktionskraft und des normalen ($M_N$) und tangentialen ($M_T$) Reaktionsmoments, die sich aus dem Kontakt zwischen Schaufel und Gehäuse aus den berechneten Drücken ergeben;
- Dimensionierung (E6) der Turbomaschine je nach den berechneten Abständen, Drücken, Kräften und Momenten.

**2.** Verfahren nach Anspruch 1, wobei die Koordinaten der Enden der Vorder- und der Hinterkante der Schaufel in der mit dem Gehäuse verknüpften Skala ($X_c$, $Y_c$, $Z_c$) als Funktion der Freiheitsgrade der Scheibe, des Gehäuses und der Schaufel ausgedrückt werden (E2).

**3.** Verfahren nach Anspruch 2, wobei die Freiheitsgrade unter Translationen und Kippen der Scheibe und des Gehäuses, einer Biegung der Schaufel an ihrer Spitze und einer radialen Verformung des Gehäuses liegen.

**4.** Verfahren nach Anspruch 2 oder 3, wobei die Freiheitsgrade zu den folgenden gehören:

- Translationen der Scheibe um eine erste Länge ($X_d(t)$) und eine zweite Länge ($Y_d(t)$) nach zwei Achsen (x, y) quer zur Achse der Turbomaschine (z), wobei die beiden Querachsen (x, y) und die Achse der Turbomaschine (z) eine erste Skala (x, y, z) definieren, die mit der Welle verknüpft ist;

- Kippen der Scheibe in einem ersten Winkel ($\varphi_{xd}$(t)) um die erste Achse der ersten Skala (x), wobei eine zweite Skala ($x_1$, $y_1$, $z_1$) durch Drehung der ersten Skala (x, y, z) des ersten Winkels ($\varphi_{xd}$(t)) um die erste Achse der ersten Skala (x) erzielt wird;

- Kippen der Scheibe in einem zweiten Winkel ($\varphi_{yd}$(t)) um die zweite Achse der zweiten Skala ($y_1$), wobei eine dritte Skala ($X_2$, $Y_2$, $z_2$) durch Drehung der zweiten Skala ($x_1$, $y_1$, $z_1$) des zweiten Winkels ($\varphi_{yd}$(t)) um die zweite Achse der zweiten Skala ($y_1$) erzielt wird;

- Winkelpositionierung der Schaufel gegenüber der zweiten Achse der dritten Skala ($y_2$), wobei die Winkelpositionierung einer Drehung in einem dritten Winkel ($\alpha_j$) um die dritte Achse der dritten Skala ($Z_2$) entspricht, wobei die mit der Scheibe (Xb, Yb, Zb) verbundene Skala eine vierte Skala bildet, die durch Drehung der dritten Skala ($x_2$, $y_2$, $z_2$) des dritten Winkels ($\alpha_j$) um die dritte Achse der dritten Skala ($z_2$) erzielt wird;

- Biegung der Schaufel an ihrer Spitze um eine dritte Länge ($x_b$(t)) entlang einer ersten Achse ($x_b$) einer fünften Skala ($x_b$, $y_b$, $z_b$), die durch Drehen der vierten Skala (Xb, Yb, Zb) in einem vierten Winkel ($\beta$) um die zweite Achse der vierten Skala (Yb) erzielt wird.

- Translationen des Gehäuses einer vierten Länge ($x_c$(t)) und einer fünften Länge ($y_c$(t)) entlang den beiden ersten Achsen der ersten Skala (x, y);

- Kippen des Gehäuses in einem fünften Winkel ($\varphi_{xc}$(t)) um die erste Achse der ersten Skala (x), wobei eine sechste Skala ($x_{c1}$, $y_{c1}$, $z_{c1}$) durch Drehung der ersten Skala (x, y, z) des fünften Winkels ($\varphi_{xc}$(t)) um die erste Achse der ersten Skala (x) erzielt wird;

- Kippen des Gehäuses in einem sechsten Winkel $\varphi_{yc}$(t) um die zweite Achse der ersten Skala y, wobei die mit dem Gehäuse verbundene Skala ($x_c$, $y_c$, $z_c$) durch Drehung der sechsten Skala ($x_{c1}$, $y_{c1}$, $z_{c1}$) des sechsten Winkels ($\varphi_{yc}$(t)) um die zweite Achse der ersten Skala (y) erzielt wird;

- Radiale Verformung des Gehäuses um eine sechste Länge ($u(\alpha,t)$) in Bezug auf einen Radius des Gehäuses (Rc).

5. Verfahren nach Anspruch 4, bei dem die Koordinaten P' der Enden der Vorder- und der Hinterkante der Schaufel in der mit dem Gehäuse verknüpften Skala ($x_c$, $y_c$, $z_c$) mit folgender Formel ausgedrückt werden (E2) :

$$P' = \mathbf{P}_{\phi_{yc}} \mathbf{P}_{\phi_{xc}} \left( \mathbf{P}_{\phi_{xd}}^T \mathbf{P}_{\phi_{yd}}^T \mathbf{P}_{\alpha_j}^T \left( P + \mathbf{P}_\beta^T \begin{Bmatrix} x_b(t) \\ 0 \\ 0 \end{Bmatrix} \right) + \begin{Bmatrix} x_d(t) - x_c(t) \\ y_d(t) - y_c(t) \\ 0 \end{Bmatrix} \right)$$

mit:

$P_{\varphi_{xd}}$ die Matrix für den Übergang von der ersten Skala (x, y, z) zur zweiten Skala ($x_1$, $y_1$, $z_1$), $P_{\varphi_{yd}}$ die Matrix für den Übergang von der zweiten Skala ($x_1$, $y_1$, $z_1$) zur dritten Skala ($x_2$, $y_2$, $z_2$), $P_{\varphi_{xc}}$ die Matrix für den Übergang von der ersten Skala (x, y, z) zur sechsten Skala ($x_{c1}$, $y_{c1}$, $z_{c1}$) und $P\varphi p_{yc}$ die Matrix für den Übergang von der sechsten Skala ($x_{c1}$, $y_{c1}$, $z_{c1}$) zur mit dem Gehäuse verbundenen Skala ($x_c$, $y_c$, $z_c$),

$P\alpha j$ die mit der Winkelpositionierung der Schaufel auf der Scheibe verknüpfte Durchgangsmatrix,

$P\beta$ die mit der Ausrichtung der Biegung der Schaufel an ihrer Spitze verknüpfte Durchgangsmatrix, und

$$\mathbf{P}_{\alpha_j} = \begin{bmatrix} \cos\alpha_j & \sin\alpha_j & 0 \\ -\sin\alpha_j & \cos\alpha_j & 0 \\ 0 & 0 & 1 \end{bmatrix} ; \quad \mathbf{P}_\beta = \begin{bmatrix} \cos\beta & 0 & -\sin\beta \\ 0 & 1 & 0 \\ \sin\beta & 0 & \cos\beta \end{bmatrix}$$

$$\mathbf{P}_{\phi_{xd}} = \begin{bmatrix} 1 & 0 & 0 \\ 0 & \cos\phi_{xd} & \sin\phi_{xd} \\ 0 & -\sin\phi_{xd} & \cos\phi_{xd} \end{bmatrix} ; \quad \mathbf{P}_{\phi_{yd}} = \begin{bmatrix} \cos\phi_{yd} & 0 & -\sin\phi_{yd} \\ 0 & 1 & 0 \\ \sin\phi_{yd} & 0 & \cos\phi_{yd} \end{bmatrix}$$

$$\mathbf{P}_{\phi_{xc}} = \begin{bmatrix} 1 & 0 & 0 \\ 0 & \cos\phi_{xc} & \sin\phi_{xc} \\ 0 & -\sin\phi_{xc} & \cos\phi_{xc} \end{bmatrix} ; \quad \mathbf{P}_{\phi_{yc}} = \begin{bmatrix} \cos\phi_{yc} & 0 & -\sin\phi_{yc} \\ 0 & 1 & 0 \\ \sin\phi_{yc} & 0 & \cos\phi_{yc} \end{bmatrix}$$

**6.** Verfahren nach Anspruch 5, wobei die Innenfläche des Gehäuses als Drehkegel des Winkels θ, Grundradius Rb und Höhe h betrachtet wird, und der Abstand g zwischen dem Gehäuse und den Enden der Vorder- und Hinterkante der Schaufel mit folgender Formel berechnet wird (E3):

$$g(P) = \left( -\frac{R_b}{h} P'_z + R_b - \sqrt{P'^2_x + P'^2_y} + u(\alpha(P), t) \right) \cos\theta$$

mit:

$$P' = \left\{ P'_x, P'_y, P'_z \right\}^T$$

**7.** Verfahren nach einem beliebigen der vorstehenden Ansprüche 1 bis 6, wobei die Berechnung der Drücke (E4) eine an das Schaufelende und das anfängliche Spielprofil angepasste Formfunktion einsetzt.

**8.** Verfahren nach einem beliebigen der vorstehenden Ansprüche, wobei die Anpressdrücke entlang eines Strangs berechnet werden (E4), der als gerade in der Länge angenommenen wird und ein Ende der Schaufel durch lineare Interpolation aus den berechneten Abständen zwischen dem Gehäuse und den oberen Enden der Vorder- und Hinterkante der Schaufel bildet.

**9.** Verfahren nach Anspruch 8, wobei der normale $p_N$ und der tangentiale Anpressdruck $p_T$ an einem beliebigen Punkt des Strangs unter Verwendung der folgenden Formeln berechnet werden (E4):

$$p_N(c) = \frac{k_r}{l_c}(\zeta c + \eta) \text{ and } p_T(c) = \frac{k_t}{l_c}(\zeta c + \eta)$$

avec

$$\zeta = \frac{g(BF) - g(BA)}{l_c}$$

et

$$\eta = \frac{g(BF) + g(BA)}{2}$$

wobei c die Abszisse einer Position entlang des Strangs darstellt, die zwischen -|c/2 und +|1c/2 variiert, und wobei $k_r$ und $k_t$ die normale und tangentiale Steifigkeit beim Kontakt sind.

**10.** Verfahren nach Anspruch 9, bei dem die normale $F_N$ und tangentiale $F_T$ Reaktionskraft und das normale $M_N$ und das tangentiale $M_T$ Reaktionsmoment, die sich aus dem Kontakt zwischen einer Schaufel und dem Gehäuse ergeben, unter Verwendung der folgenden Formeln berechnet werden (E5):

$$F_N = \int_{c_1}^{c_2} p_N(c)dc \quad F_T = \int_{c_1}^{c_2} p_T(c)dc \quad M_N = \int_{c_1}^{c_2} c\, p_N(c)dc$$

$$M_T = \int_{c_1}^{c_2} c\, p_N(c)dc$$

wobei cl und c2 die minimale und maximale Abszisse aller mit dem Gehäuse in Kontakt stehenden Strangpositionen ist.

11. Rechnerprogrammprodukt umfassend Codeanweisungen zum Ausführen eines Auslegungsverfahrens nach einem beliebigen der vorstehenden Ansprüche, wenn dieses Programm von einem Prozessor ausgeführt wird.

12. Vorrichtung zur Auslegung einer Turbomaschine (7), **dadurch gekennzeichnet, dass** sie Datenverarbeitungsmittel (6) umfasst, die Folgendes umfassen:

- ein Modul zum Erfassen der Koordinaten (P) der Enden einer Vorderkante (BA) und einer Hinterkante (BF) einer Turbomaschinenschaufel in einer mit einer zuvor bestimmten Turbomaschinenscheibe (Xb, Yb, Zb) verknüpften Skala, wobei die Turbomaschine ein Gehäuse und die Scheibe umfasst, an dem zumindest die Schaufel befestigt ist, das Gehäuse die Scheibe und die zumindest eine Schaufel umgibt, wobei die Scheibe durch eine Welle um eine Achse, die Achse der Turbomaschine (z), in Drehung versetzt wird;
- ein Modul zum Ausdrücken der Koordinaten (P') der oberen Enden der Vorder- und der Hinterkante der Schaufel ausgehend von den erfassten Koordinaten in einer mit dem Gehäuse ($x_c$, $y_c$, zc) verknüpften Skala;
- ein Modul zum Berechnen des Abstands (g) zwischen dem Gehäuse und der Vorder- und der Hinterkante der Schaufel ausgehend von den Koordinaten (P') der Vorderkante und der Hinterkante der Schaufel in der mit dem Gehäuse verknüpften Skala ($x_c$, $y_c$, $z_c$);
- ein Modul zur Berechnung des normalen ($p_N$) und des tangentialen ($p_T$) Anpressdrucks entlang dem Ende der Schaufel ausgehend vom berechneten Abstand (g);
- ein Modul zur Berechnung der normalen ($F_N$) und der tangentialen ($F_T$) Reaktionskraft und des normalen ($M_N$) und des tangentialen ($M_T$) Reaktionsmoments, die sich aus dem Kontakt zwischen Schaufel und Gehäuse aus den berechneten Drücken ergeben;
- ein Modul zur Auslegung der Turbomaschine je nach den berechneten Abständen, Drücken, Kräften und Momenten.

## Claims

1. A method for dimensioning a turbine engine comprising a casing (1) and a disc (2) on which is fixed at least one blade (3), said casing enclosing the disc and the at least one blade, said disc (2) being driven in rotation by a shaft (4) about an axis, so-called axis of the turbine engine (z), and said blade comprising a leading edge (BA) and a trailing edge (BF), said method being **characterized in that** it comprises performing by data-processing means (6) steps of:

- acquisition (E1) of the coordinates (P) of the ends of the leading edge and of the trailing edge of the blade in a reference mark linked to the disc (Xb, Yb, Zb) determined previously;
- from said acquired coordinates (P), expression (E2) of the coordinates (P') of the upper ends of the leading edge and of the trailing edge of the blade in a reference mark linked to the casing ($x_c$, $y_c$, $z_c$);
- calculation (E3) of the distance (g) between the casing and the ends of the leading edge and of the trailing edge of the blade from the coordinates (P') of the ends of the leading edge and of the trailing edge of the blade in the reference mark linked to the casing ($x_c$, $y_c$, $z_c$);
- calculation (E4) of the normal ($p_N$) and tangential ($p_T$) contact pressures between the blade and the casing along the end of the blade from the calculated distance (g);
- calculation (E5) of the normal ($F_N$) and tangential ($F_T$) reaction forces and the normal ($M_N$) and tangential ($M_T$) moments of reaction resulting from the contact between the blade and the casing from the calculated pressures;
- dimensioning (E6) of the turbine engine as a function of the calculated distances, pressures, forces and moments.

2. The method according to claim 1, wherein the coordinates of the ends of the leading edge and of the trailing edge of the blade in the reference mark linked to the casing ($x_c$, $y_c$, $z_c$) are expressed (E2) as a function of degrees of freedom of the disc, the casing and the blade.

3. The method according to claim 2, wherein said degrees of freedom are from among translations and tilting movements of the disc and of the casing, deflection of the blade at its tip and radial deformation of the casing.

4. The method according to claim 2 or 3, wherein said degrees of freedom are from among:

- translations of the disc by a first length ($x_d(t)$) and a second length ($y_d(t)$) along two axes (x, y) transverse to the axis of the turbine engine (z), the two transverse axes (x,y) and the axis of the turbine engine (z) defining a first reference mark (x, y, z) linked to the shaft;

- tilting of the disc at a first angle ($\varphi_{xd}(t)$) around the first axis of the first reference mark (x), a second reference mark ($x_1$, $y_1$, $z_1$) being obtained by rotation of the first reference mark (x, y, z) of the first angle ($\varphi_{xd}(t)$) around the first axis of the first reference mark (x);

- tilting of the disc at a second angle ($\varphi_{yd}(t)$) around the second axis of the second reference mark ($y_1$), a third reference mark ($x_2$, $y_2$, $z_2$) being obtained by rotation of the second reference mark ($x_1$, $y_1$, $z_1$) of the second angle ($\varphi_{yd}(t)$) around the second axis of the second reference mark (yi);

- angular positioning of the blade relative to the second axis of the third reference mark ($y_2$), said angular positioning corresponding to rotation at a third angle ($\alpha_j$) around the third axis of the third reference mark ($z_2$), the reference mark linked to the disc (Xb, Yb, Zb) forming a fourth reference mark obtained by rotation of the third reference mark ($x_2$, $y_2$, $z_2$) of the third angle ($\alpha_j$) around the third axis of the third reference mark ($z_2$);

- deflection of the blade at its tip by a third length ($x_b(t)$) along a first axis ($x_b$) of a fifth reference mark ($x_b$,$y_b$,$z_b$) obtained by rotation of the fourth reference mark (Xb, Yb, Zb) of a fourth angle (β) around the second axis of the fourth reference mark (Yb);

- translations of the casing by a fourth length ($x_c(t)$) and by a fifth length ($y_c(t)$) along the two first axes of the first reference mark (x,y);

- tilting of the casing by a fifth angle ($\varphi_{xc}(t)$) around the first axis of the first reference mark (x), a sixth reference mark ($x_{c1}$, $y_{c1}$, $z_{c1}$) being obtained by rotation of the first reference mark (x, y, z) of the fifth angle ($\varphi_{xc}(t)$) around the first axis of the first reference mark (x);

- tilting of the casing by a sixth angle ($\varphi_{yc}(t)$) around the second axis of the first reference mark y, the reference mark ($x_c$, $y_c$, $z_c$) linked to the casing being obtained by rotation of the sixth reference mark ($x_{c1}$, $y_{c1}$, $z_{c1}$) of the sixth angle ($\varphi_{yc}(t)$) around the second axis of the first reference mark (y);

- radial deformation of the casing by a sixth length ($u(\alpha,t)$) relative to a radius of the casing (Rc).

5. The method according to claim 4, wherein the coordinates P' of the ends of the leading edge and of the trailing edge of the blade expressed in the reference mark linked to the casing ($x_c$, $y_c$, $z_c$) are expressed (E2) by means of the following formula:

$$P' = \mathbf{P}_{\phi_{yc}} \mathbf{P}_{\phi_{xc}} \left( \mathbf{P}_{\phi_{x_d}}^T \mathbf{P}_{\phi_{y_d}}^T \mathbf{P}_{\alpha_j}^T \left( P + \mathbf{P}_\beta^T \left\{ \begin{array}{c} x_b(t) \\ 0 \\ 0 \end{array} \right\} \right) + \left\{ \begin{array}{c} x_d(t) - x_c(t) \\ y_d(t) - y_c(t) \\ 0 \end{array} \right\} \right)$$

With:

$P_{\varphi_{xd}}$ the transformation matrix from the first reference mark (x, y, z) to the second reference mark ($x_1$, $y_1$, $z_1$), $P_{\varphi_{yd}}$ the transformation matrix from the second reference mark ($x_1$, $y_1$, $z_1$) to the third reference mark ($x_2$, $y_2$, $z_2$), $P_{\varphi_{xc}}$ the transformation matrix from the first reference mark (x, y, z) to the sixth reference mark ($x_{c1}$, $y_{c1}$, $z_{c1}$) and $P_{\varphi_{yc}}$ the transformation matrix from the sixth reference mark ($x_{c1}$, $y_{c1}$, $z_{c1}$) to the reference mark linked to the casing ($x_c$, $y_c$, $z_c$),

$P_{\alpha}j$ the transformation matrix linked to the angular positioning of the blade on the disc,

Pβ the transformation matrix linked to the orientation of the deflection of the blade at its tip,

and

$$\mathbf{P}_{\alpha_j} = \begin{bmatrix} \cos \alpha_j & \sin \alpha_j & 0 \\ -\sin \alpha_j & \cos \alpha_j & 0 \\ 0 & 0 & 1 \end{bmatrix} ; \quad \mathbf{P}_\beta = \begin{bmatrix} \cos \beta & 0 & -\sin \beta \\ 0 & 1 & 0 \\ \sin \beta & 0 & \cos \beta \end{bmatrix}$$

$$\mathbf{P}_{\phi_{x_d}} = \begin{bmatrix} 1 & 0 & 0 \\ 0 & \cos \phi_{x_d} & \sin \phi_{x_d} \\ 0 & -\sin \phi_{x_d} & \cos \phi_{x_d} \end{bmatrix} ; \quad \mathbf{P}_{\phi_{y_d}} = \begin{bmatrix} \cos \phi_{y_d} & 0 & -\sin \phi_{y_d} \\ 0 & 1 & 0 \\ \sin \phi_{y_d} & 0 & \cos \phi_{y_d} \end{bmatrix}$$

$$\mathbf{P}_{\phi_{x_c}} = \begin{bmatrix} 1 & 0 & 0 \\ 0 & \cos\phi_{x_c} & \sin\phi_{x_c} \\ 0 & -\sin\phi_{x_c} & \cos\phi_{x_c} \end{bmatrix} ; \ \mathbf{P}_{\phi_{y_c}} = \begin{bmatrix} \cos\phi_{y_c} & 0 & -\sin\phi_{y_c} \\ 0 & 1 & 0 \\ \sin\phi_{y_c} & 0 & \cos\phi_{y_c} \end{bmatrix}$$

6. The method according to claim 5, wherein the internal surface of the casing being considered to form a circular cone of angle θ, base radius Rb and height h, the distance g between the casing and the ends of the leading edge and of the trailing edge of the blade is calculated (E3) by means of the following formula:

$$g(P) = \left( -\frac{R_b}{h}P'_{\mathbf{z}} + R_b - \sqrt{P'^2_{\mathbf{x}} + P'^2_{\mathbf{y}}} + u(\alpha(P), t) \right) \cos\theta$$

with

$$P' = \left\{ P'_{\mathbf{x}}, P'_{\mathbf{y}}, P'_{\mathbf{z}} \right\}^T$$

7. The method according to one of claims 1 to 6, wherein calculation of pressures (E4) performs a shaping function adapted to the end of the blade and to the profile of initial clearance.

8. The method according to one of the preceding claims, wherein the contact pressures are calculated (E4) along a cord assumed to be rectilinear of length lc forming an end of the blade by a linear interpolation from the calculated distances between the casing and the upper ends of the leading edge and of the trailing edge of the blade.

9. The method according to claim 8, wherein the normal $p_N$ and tangential $p_T$ contact pressures at any point of said cord are calculated (E4) by means of the following formulas:

$$p_N(c) = \frac{k_r}{l_c}(\zeta c + \eta) \ \text{and} \ p_T(c) = \frac{k_t}{l_c}(\zeta c + \eta)$$

avec

$$\zeta = \frac{g(BF) - g(BA)}{l_c}$$

et

$$\eta = \frac{g(BF) + g(BA)}{2}$$

c representing the abscissa of a position along said cord varying between -lc/2 and +lc/2 and, $k_r$ and $k_t$ being the normal and tangential degrees of stiffness on contact.

10. The method according to claim 9, wherein the normal $F_N$ and tangential $F_T$ reaction forces and the normal $M_N$ and tangential $M_T$ moments of reaction resulting from the contact between a blade and the casing are calculated (E5) by means of the following formulas:

$$F_N = \int_{c_1}^{c_2} p_N(c)dc \quad F_T = \int_{c_1}^{c_2} p_T(c)dc \quad M_N = \int_{c_1}^{c_2} c\, p_N(c)dc$$

$$M_T = \int_{c_1}^{c_2} c\, p_N(c)dc$$

$c_1$ and $c_2$ being the minimum and maximum abscissae of all the positions of the cord of the blade in contact with the casing.

11. A computer program product comprising code instructions for executing a method for dimensioning, according to any one of the preceding claims when this program is executed by a processor.

12. A device for dimensioning a turbine engine (7) **characterized in that** it comprises data-processing means (6) comprising:

- a module for acquiring the coordinates (P) of the ends of a leading edge (BA) and a trailing edge (BF) of a blade of a turbine engine in a reference mark linked to a disc of the turbine engine ($X_b$, $Y_b$, $Z_b$) determined previously, said turbine engine comprising a casing and said disc on which is fixed at least said blade, said casing enclosing the disc and the at least one blade, said disc being driven in rotation by a shaft about an axis, so-called axis of the turbine engine (z);
- a module for expressing the coordinates (P') of the upper ends of the leading edge and of the trailing edge of the blade in a reference mark linked to the casing ($x_c$, $y_c$, $z_c$) from said acquired coordinates;
- a module for calculating the distance (g) between the casing and the ends of the leading edge and of the trailing edge of the blade from the coordinates (P') of the ends of the leading edge and of the trailing edge of the blade in the reference mark linked to the casing ($x_c$, $y_c$, $z_c$);
- a module for calculating the normal ($p_N$) and tangential ($p_T$) contact pressures between the blade and the casing along the end of the blade from the calculated distance (g);
- a module for calculating the normal ($F_N$) and tangential ($F_T$) reaction forces and the normal ($M_N$) and tangential ($M_T$) moments of reaction resulting from the contact between the blade and the casing from the calculated pressures;
- a module for dimensioning the turbine engine as a function of the calculated distances, pressures, forces and moments.

FIG. 1

FIG. 2

FIG. 3a

FIG. 3b

FIG. 4

FIG. 5

FIG. 6

FIG. 7

FIG. 8

FIG. 9

EP 3 152 406 B1

Profil de jeu
interpolé

Portion de corde en
contact avec le carter

P(BF)

g(BA)>0

c

g(BF)<0

P(BA)

## FIG. 10a

Pression
de contact

P(BA)

P(BF)

-lc/2

c

lc/2

## FIG. 10b

E1 — Acquisition des coordonnées P dans repère (Xb, Yb, Zb)

E2 — Expression des coordonnées P' dans repère lié au carter (xc, yc, zc)

E3 — Calcul de la distance g

E4 — Calcul des pressions de contact $P_N$ et $P_T$

E5 — Calcul des forces de réaction et des moments de réaction

E6 — Dimensionnement de la turbomachine

## FIG. 11

27

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1890009 A